Europäisches Patentamt

European Patent Office

Office européen des brevets

(11) Numéro de publication: **0 403 712**
**A1**

## (12) DEMANDE DE BREVET EUROPEEN

(21) Numéro de dépôt: 89401763.1

(22) Date de dépôt: 22.06.89

(51) Int. Cl.5: **H05K 7/20**

(43) Date de publication de la demande:
27.12.90 Bulletin 90/52

(84) Etats contractants désignés:
DE ES GB IT NL SE

(71) Demandeur: INNOVATIONS THERMIQUES
ZA de Pré-Millet Montbonnot-Saint-Martin
F-38330 Saint-Ismier(FR)

(72) Inventeur: Teytu, André Marius Régis
27, rue Mallifaud
F-38100 Grenoble(FR)
Inventeur: Lebrun, Laurent Claude Jacques
Lucien
5, rue Pal de Fer
F-38240 Meylan(FR)

(74) Mandataire: Casalonga, Axel et al
BUREAU D.A. CASALONGA - JOSSE
Morassistrasse 8
D-8000 München 5(DE)

(54) Connecteur thermique débrochable.

(57) Connecteur thermique débrochable (2) destiné à effectuer un transfert thermique entre au moins deux pièces (7, 16), par exemple un composant électronique et un évacuateur de chaleur, comprenant deux parties (4, 3) comprenant respectivement lesdites pièces (7, 16) et munies de moyens (5) de connexion entre elles, par exemple le connecteur électrique d'un circuit imprimé sur un support, ainsi qu'au moins un caloduc (12) qui est thermiquement associé d'une part à l'une et d'autre part à l'autre desdites pièces et qui est d'une part solidaire d'une (3) desdites parties et d'autre part relié à l'autre (4) de ces parties de manière débrochable dans le même sens que les moyens (5) de connexion de ces parties (3, 4).

FIG.1

# CONNECTEUR THERMIQUE DEBROCHABLE

La présente invention concerne un connecteur thermique débrochable destiné à effectuer des transferts thermiques.

On rencontre de plus en plus, en électricité ou en électronique, des cartes de circuits imprimés portant des composants ayant une forte dissipation de chaleur, ces cartes de circuit imprimé étant montées de manière amovible sur des supports fixes par l'intermédiaire de connecteurs électriques. A l'heure actuelle pour effectuer la dissipation de chaleur, on monte sur les cartes de circuits imprimés des évacuateurs de chaleur ou radiateurs qui sont thermiquement associés aux composants à refroidir et qui sont en général des pièces métalliques à ailettes. Lorsque les quantités de chaleur à évacuer deviennent importantes, ces radiateurs fixés sur les cartes de circuits imprimés deviennent volumineux et lourds. Cette solution présente de nombreux inconvénients notamment lors du changement des cartes de circuits imprimés et lors de leur transport en vue notamment de leur maintenance. De plus, lorsque plusieurs cartes sont disposées parallèlement sur un même support, elles doivent être, à cause des radiateurs, très écartées.

Pour remédier notamment à ces inconvénients, la présente invention propose un connecteur thermique débrochable s'appliquant avantageusement aux cartes de circuits imprimés sans pour autant être limité à cette application.

Le connecteur thermique débrochable selon la présente invention, destiné à effectuer un transfert thermique entre au moins deux pièces, comprend deux parties comprenant respectivement lesdites pièces et munies de moyens de connexion entre elles ainsi qu'au moins un caloduc qui est thermiquement associé d'une part à l'une et d'autre part à l'autre desdites pièces et qui est d'une part solidaire d'une desdites parties et d'autre part relié à l'autre de ces parties de manière débrochable dans le même sens que lesdits moyens de connexion de ces parties.

Dans une variante de réalisation , les moyens de liaison débrochables permettant de relier ladite pièce et le caloduc constituent des moyens de transfert thermique entre cette pièce et ce caloduc.

Selon la présente invention, ladite pièce est de préférence reliée de manière débrochable au caloduc au moins en partie par des moyens de contact déformable élastiquement, ces moyens déformables élastiquement pouvant être formés par au moins une bague ou une languette.

Dans une variante de réalisation, ladite pièce reliée de manière débrochable au caloduc comprend de préférence un orifice ou passage dans lequel est disposé une bague déformable élastiquement dans laquelle est engagé de manière débrochable le caloduc.

Pour certaines applications, l'une desdites pièces peut comprendre des moyens d'évacuation de chaleur constituer par exemple par un radiateur à surfaces.

COnformément à la présente invention, au moins l'une desdites pièces peut, dans une variante, comprendre au moins un autre caloduc thermiquement associé audit caloduc, l'un de ces caloducs comprenant de préférence un évidement dans l'une de ses extrémités, dans lequel est engagé l'autre caloduc.

Selon la présente invention, le caloduc peut avantageusement être monté solidaire de ladite partie par l'intermédiaire de moyens élastiques déformables afin de palier les problèmes d'alignement.

Dans une application particulièrement intéressante, l'une desdites pièces peut être formée par ou reliée thermiquement à au moins un composant électrique ou électronique, notamment par l'intermédiaire d'un isolant électrique.

Dans une application équivalente, lesdites parties peuvent être formées l'une par une carte de circuit imprimé et l'autre par un support de cette carte, lesdits moyens de connexion étant de préférence formés par le connecteur électrique débrochable de cette plaque sur son support et ledit caloduc étant relié thermiquement d'une part à au moins un composant électrique ou électronique monté sur cette carte et d'autre part à un évacuateur de chaleur solidaire de ce support.

Dans un montage particulier, ledit caloduc est débrochable de ladite pièce axialement. Il pourrait tout aussi bien l'être radialement.

La présente invention sera mieux comprise à l'étude de montages incluant des connecteurs thermiques débrochables décrits à titre d'exemples non limitatifs et illustrés par le dessin sur lequel :

- la figure 1 représente, en coupe longitudinale, un premier montage de connecteur thermique débrochable selon la présente invention ;

- la figure 2 représente une coupe transversale selon II-II du montage de 18 figure 1 ;

- la figure 3 représente, en coupe longitudinale, un deuxième montage d'un connecteur thermique débrochable selon la présente invention ;

- et la figure 4 représente, en coupe longitudinale, un troisième montage de plusieurs connecteurs thermiques débrochables selon la présente invention.

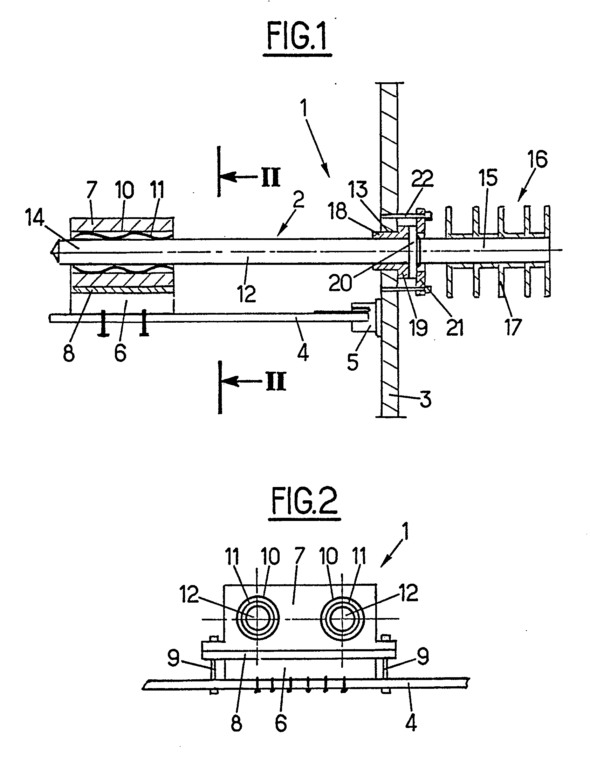

Sur les figures 1 et 2, on a représenté un montage, repéré d'une manière générale par la référence 1, d'un connecteur thermique débrochable repéré d'une manière générale par la référence 2. Ce montage 1 comprend une plaque support 3 verticale sur laquelle est montée, perpendiculairement, une carte de circuit imprimé 4, par l'intermédiaire d'un connecteur électrique débrochable représenté schématiquement qui porte la carte de circuit imprimé 4 et dans lequel le bord de cette dernière est monté de manière débrochable perpendiculairement à la plaque support 3. Cette carte de circuit imprimé 4 porte notamment un composant électronique 6 qui, dans l'exemple, est plat et duquel il est nécessaire d'évacuer la chaleur qu'il fournit.

Le connecteur thermique débrochable 2 comprend une pièce 7 formée par un bloc métallique qui est en appui sur le composant électronique 6 par l'intermédiaire d'une feuille d'isolant électrique 8, de préférence bonne conductrice de la chaleur, et qui est fixée sur la plaque de circuit imprimé 4, de part et d'autre du composant électronique 6, par l'intermédiaire de vis 9. Cette pièce métallique 7 présente deux orifices cylindriques traversant 10 qui s'étendent perpendiculairement à la plaque support 3 et dans lesquels sont disposées des bagues ou languettes annulaires 11 déformables élastiquement, ces bagues ou languettes étant de préférence métalliques et bonnes conductrices de la chaleur.

Le connecteur thermique débrochable 2 comprend également deux caloducs 12 qui s'étendent perpendiculairement à la plaque support 3 et au travers d'un passage 13 de cette dernière. Les parties d'extrémité 14 de ces caloducs 12 sont engagées dans les bagues 11 et compriment ces dernières entre la paroi extérieure des caloducs 12 et la paroi intérieure des orifices 10 ménagés dans la pièce métallique 7 de telle sorte que le caloduc 11 est maintenu de manière débrochable dans la pièce 7 et qu'il existe un bon contact thermique entre le caloduc 12 et cette pièce 7. Les autres parties d'extrémité 15 des caloducs 12, qui s'étendent largement au-delà de la plaque support 3, portent une pièce repérée d'une manière générale par la référence 16 qui forme un évacuateur de chaleur et qui est constitué de plusieurs ailettes annulaires 17, de préférence métalliques enfilées successivement sur les extrémités des caloducs 12.

En outre, les caloducs 12 sont montés solidaires de la plaque support 3 de la manière suivante. Entre les caloducs 12 et les passages 13 de la plaque support 3 sont montées des bagues annulaires 18 formées en un matérieu déformable élastiquement et présentant des épaulements 19 en appui sur la face extérieure de la plaque support 3. Des bagues annulaires 20 fixées aux caloducs 12 sont insérées entre les épaulements 19 des bagues 18 et sont maintenues par des rondelles 21 fixées sur la plaque support 3 par l'intermédiaire de vis 22.

La chaleur produite par le composant électronique 6 est transmise à la pièce 7 et cette chaleur est transférée par les caloducs 12 de leurs extrémités 14 vers leurs extrémités 15 et est dissipée grâce aux radiateurs constitués par les ailettes annulaires 17, la chaleur à dissiper étant ainsi transférée de l'autre côté de la plaque support 3 par rapport à la position de la carte de circuit imprimé 4.

En tirant la carte de circuit imprimé 4 et la pièce 7 qu'elle porte, perpendiculairement à la plaque support 3, cette carte 4 se débroche du connecteur électrique 5 et la pièce 7 se débroche des extrémités 14 des caloducs 12 et cet ensemble se trouve ainsi démonté. Pour remonter la carte de circuit imprimé 4, on embroche la pièce 7 sur les extrémités 14 des caloducs 12 et le bord de la carte de circuit imprimé 4 dans le connecteur électrique 5. La bague 18 en matériau déformable élastiquement permet d'absorber un certain défaut de parallélisme du connecteur électrique débrochable 5 et du connecteur thermique débrochable 2.

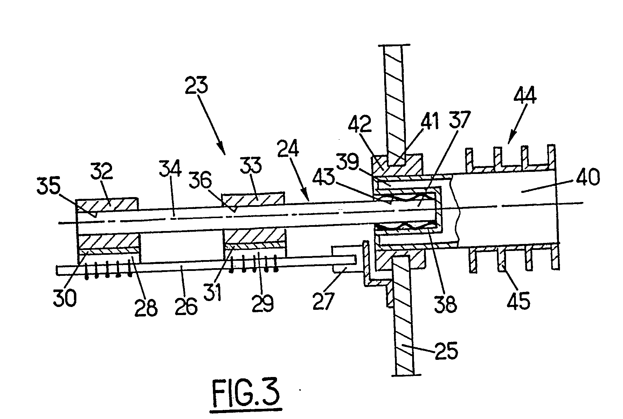

Sur la figure 3, on a représenté un autre montage repéré d'une manière générale par la référence 23, d'un autre connecteur thermique débrochable repéré d'une manière générale par la référence 24.

Comme précédemment, ce montage 23 comprend une plaque support verticale 25 sur laquelle est montée, perpendiculairement, une carte de circuit imprimé 26 par l'intermédiaire d'un connecteur électrique débrochable 27.

Cette carte de circuit imprimé 26 porte, d'un côté, deux composants électroniques 28 et 29 sur lesquels sont appliqués, par l'intermédiaire de plaques d'isolement électrique 30 et 31 des pièces 32 et 33 formées par des blocs métalliques qui sont fixés sur la carte de circuit imprimé 26 par exemple comme dans l'exemple précédent.

Le connecteur thermique 24 comprend un caloduc 34 qui s'étend perpendiculairement à la plaque support 25 dans des orifices traversant 35 et 36 des pièces 32 et 33 dans lesquelles ils sont fixés en contact avec leurs parois, ce caloduc 34 présentant une partie d'extrémité 37 qui est engagée dans un évidement axial 38 ménagé dans la partie d'extrémité 39 d'un second caloduc 40. L'extrémité 39 de ce caloduc 40 est fixée dans un passage 41 de la plaque support 25 par l'intermédiaire d'une bague en un matériau de préférence déformable élastiquement. Entre la partie d'extrémité 37 du caloduc 34 et la paroi intérieure de l'évidement 38 du caloduc 40 est disposée une bague ou languette annulaire (43) en un materiau déformable élastiquement de préférence métallique et bon conducteur de la chaleur.

Sur le caloduc 40 est monté un évacuateur de chaleur 44 situé de l'autre côté de la plaque support 25 par rapport à la carte de circuit imprimé 26, cet évacuateur de chaleur 40 étant formé, comme précédemment, de plusieurs ailettes annulaires 45 empilées successivement et constituant un radiateur métallique.

Dans cet exemple, la chaleur émise par les composants électroniques 28 et 29 est transmise aux pièces 32 et 33, le caloduc 34 transfère la chaleur de ces pièces 32 et 33 au caloduc 40 duquel la chaleur est évacuée grâce aux ailettes 45.

Lorsqu'on souhaite retirer la carte de circuit imprimé 26, on tire sur cette dernière perpendiculairement à la plaque support 25. La carte de circuit imprimé 26 se débroche du connecteur électrique 27 et l'extrémité 37 du caloduc 34 se débroche de la bague 43 insérée dans l'évidement 38 du caloduc 40 qui reste fixé sur la plaque support 25. Pour remonter la carte de circuit imprimé 26 équipée des pièces 32 et 33 et du caloduc 34, on effectue l'opération inverse.

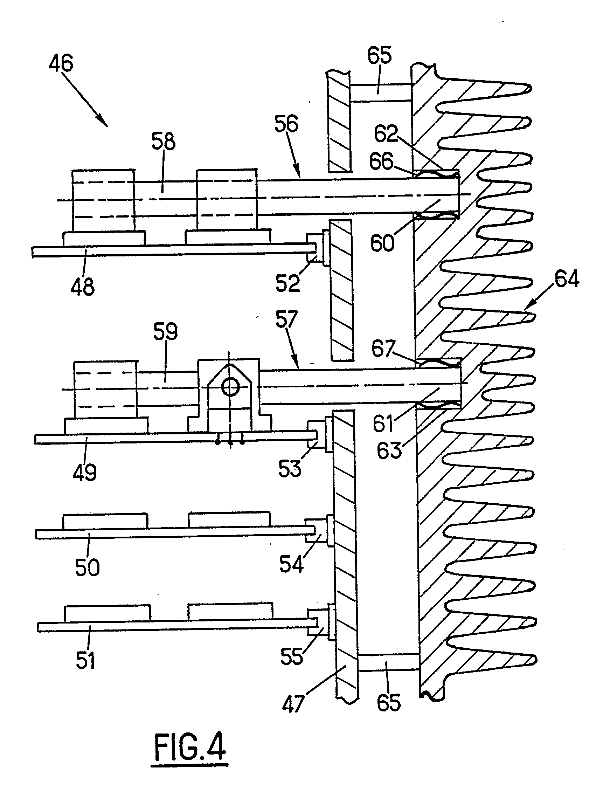

En se reportant à la figure 4, on voit qu'on a représenté un montage repéré d'une manière générale par la référence 46 qui comprend une plaque support verticale 47 sur laquelle sont montées, parallèlement et à distance, quatre cartes de circuits imprimés 48 à 51 par l'intermédiaire de connecteurs électriques débrochables 52 à 55, les cartes 48 à 51 s'étendant perpendiculairement à la plaque support 47.

Parmi les cartes de circuits imprimés montées sur la plaque support 47, les cartes 48 et 49 sont équipées de connecteurs thermiques débrochables 56 et 57.

Ces connecteurs thermiques débrochables 56 et 57 se distinguent du connecteur thermique débrochable 24 décrit en référence à la figure 3 par le fait que leurs caloducs 58 et 59 s'étendent largement au-delà de la plaque-support 47 et leurs parties d'extrémité 60 et 61 sont engagées dans des évidements 62 et 63 d'un évacuateur de chaleur unique constitué par un radiateur à surface repéré d'une manière générale par la référence 64 qui est monté à distance et parallèlement sur la plaque support 47 par l'intermédiaire de pattes 65. Des bagues ou languettes annulaires en un matériau métallique déformable élastiquement sont insérées entre les parties d'extrémité 60 et 61 des caloducs 58 et 59 et les parois des évidements 62 et 63.

On peut donc observer que le radiateur 64 est utilisé pour la dissipation de la chaleur émise par les composants portés respectivement par les cartes de circuits imprimés 48 et 49, la chaleur étant transférée vers ce radiateur 64 grâce aux caloducs 58 et 59.

Lorsqu'on souhaite démonter l'une des cartes de circuits imprimés 48 ou 49 ou lorsqu'on souhaite les remonter, les opérations se produisent de la même manière que dans l'exemple décrit en référence aux figures 3, les extrémités 60 et 61 des caloducs 58 et 59 se débrochant ou s'embrochant dans les évidements 62 et 63 du radiateur 64 par l'intermédiaire des bagues ou languettes déformables élastiquement 66 et 67.

On peut voir sur la figure 4 que, grâce aux connecteurs thermiques employés, les cartes de circuits imprimés peuvent être relativement rapprochées tout en permettant une grande évacuation de chaleur grâce au radiateur 64 à grande surface placé à l'opposé de ces cartes par rapport à la plaque support 47.

La présente invention ne se limite pas aux exemples ci-dessus décrits. Bien des variantes de réalisation sont en effet possible sans sortir du cadre défini par les revendications annexées.

## Revendications

1. Connecteur thermique débrochable (2) destiné à effectuer un transfert thermique entre au moins deux pièces (7, 16) de respectivement deux parties (4, 3) présentant entre elles des moyens (5) de connexion débrochables, caractérisé par le fait qu'il comprend au moins un caloduc (12) qui est thermiquement associé d'une part à l'une et d'autre part à l'autre desdites pièces et qui est d'une part solidaire d'une (3) desdites parties et d'autre part relié 4 l'autre (4) de ces parties de manière débrochable dans le même sens que les moyens (5) de connexion de ces parties (3, 4).

2. Connecteur thermique débrochable selon la revendication 1, caractérisé par le fait que les moyens de liaison débrochables permettant de relier ladite pièce et le caloduc (12) constituent des moyens de transfert thermique entre cette pièce et ce caloduc.

3. Connecteur thermique débrochable selon l'une des revendications précédentes, caractérisé par le fait que ladite pièce (7) est reliée de manière débrochable au caloduc (12) au moins en partie par des moyens de contact déformable élastiquement (11).

4. Connecteur thermique débrochable selon la revendication 3, caractérisé par le fait que lesdits moyens déformables élastiquement (4) sont formés par au moins une languette ou bague.

5. Connecteur thermique débrochable selon l'une quelconque des revendications précédentes, caractérisé par le fait que ladite pièce (7) reliée de manière d'ébrochable au caloduc (12) comprend un orifice ou passage (10) dans lequel est disposé une bague ou languette déformable élastiquement (11) dans laquelle est engagé de manière débrochable le caloduc (12).

6. Connecteur thermique débrochable selon l'une quelconque des revendications précédentes, caractérisé par le fait que l'une desdites pièces comprend des moyens d'évacuation de chaleur (17).

7. Connecteur thermique débrochable selon l'une quelconque des revendications précédentes, caractérisé par le fait qu'au moins l'une (44) desdites pièces comprend un autre caloduc (40) thermiquement associé audit caloduc (34).

8. Connecteur thermique débrochable selon la revendication 7, caractérisé par le fait que l'un desdits caloducs (34, 40) comprend, dans l'une de ses extrémités, un évidement dans lequel est engagé l'autre caloduc.

9. Connecteur thermique débrochable selon l'une quelconque des revendications précédentes, caractérisé par le fait que le caloduc (12) est monté solidaire de ladite partie (3) par l'intermédiaire de moyens élastiques déformables (18).

10. Connecteur thermique débrochable selon l'une quelconque des revendications précédentes, caractérisé par le fait que l'une desdites pièces est formée ou reliée thermiquement à au moins un composant électrique ou électronique (6).

11. Connecteur thermique débrochable selon la revendication 10, caractérisé par le fait que ladite pièce (7) est reliée thermiquement audit composant électrique ou électronique (6) par l'intermédiaire d'un isolant électrique (8).

12. Connecteur thermique débrochable selon l'une des revendications 10 et 11, caractérisé par le fait que l'autre pièce est formée par un évacuateur de chaleur à surface (17) relié thermiquement au caloduc (12).

13. Connecteur thermique débrochable selon l'une quelconque des revendications précédentes, caractérisé par le fait que lesdites parties sont formées l'une par une carte de circuit imprimé (4) et l'autre par un support (3) de cette carte, lesdits moyens de connexion (5) étant formés par le connecteur électrique débrochable de cette carte sur son support et ledit caloduc (12) étant relié thermiquement d'une part à au moins un composant électrique ou électronique (6) monté sur cette carte et d'autre part à un évacuateur de chaleur (16) solidaire de ce support (3).

14. Connecteur thermique débrochable selon l'une quelconque des revendications précédentes, caractérisé par le fait que ledit caloduc est débrochable de ladite pièce axialement.

## FIG.1

## FIG.2

FIG.3

FIG.4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| Y | EP-A-0168859 (N.V. PHILIP'S GLOEILAMPENFABRIEKEN)<br>* page 2, lignes 18 - 26 *<br>* page 3, lignes 15 - 32; figures 1, 2 *<br>--- | 1, 2,<br>6-9,<br>12-14 | H05K7/20 |
| Y | US-A-4330812 (K.TOKEN)<br>* colonne 2, ligne 30 - colonne 3, ligne 36; figures 1, 2 *<br>--- | 1, 2,<br>6-9,<br>12-14 | |
| E | FR-A-2625302 (INNOVATIONS THERMIQUES)<br>* le document en entier *<br>----- | 1-14 | |

| | DOMAINES TECHNIQUES RECHERCHES (Int. Cl.5 ) |
|---|---|
| | H05K |

**Le présent rapport a été établi pour toutes les revendications**

| Lieu de la recherche | Date d'achèvement de la recherche | Examinateur |
|---|---|---|
| LA HAYE | 15 FEVRIER 1990 | WOODALL C.G. |